# EUROPEAN PATENT SPECIFICATION

(11) **EP 4 002 505 B1**
(45) Date of publication and mention of the grant of the patent: **01.11.2023**
(21) Application number: 20207537.0
(22) Date of filing: 13.11.2020
(51) Int. Cl.: H10K 85/50, H10K 30/15, H10K 71/12, H10K 30/88

(54) **FUNCTIONALIZED IONIC LIQUIDS AS STABILIZERS FOR PEROVSKITE SOLAR CELLS**
FUNKTIONALISIERTE IONISCHE FLÜSSIGKEITEN ALS STABILISATOREN FÜR PEROWSKIT-SOLARZELLEN
LIQUIDES IONIQUES FONCTIONNALISÉS EN TANT QUE STABILISANTS POUR DES CELLULES SOLAIRES DE PÉROVSKITE

(43) Date of publication of application: 25.05.2022
(73) Proprietor: TOYOTA JIDOSHA KABUSHIKI KAISHA, Toyota-shi, Aichi-ken, 471-8571 (JP)
(72) Inventor: KINGE, Sachin, 1140 BRUSSELS (BE); FEI, Zhaofu, 4303 KAISERAUGST (CH); DYSON, Paul J., 1024 ECUBLENS (CH); KHAJA NAZEERUDDIN, Mohammad, 1024 ECUBLENS (CH); GAO, XiaoXin, 135 Yaguan Road, Jinnan District, Tianjin 300350 (CN); DING, Bin, 1950 SION (CH)
(74) Representative: Cabinet Beau de Loménie

(56) References cited:
- YI ZHANG ET AL: "A Strategy to Produce High Efficiency, High Stability Perovskite Solar Cells Using Functionalized Ionic Liquid-Dopants", ADVANCED MATERIALS, vol. 29, no. 36, 25 July 2017 (2017-07-25) , page 1702157, XP055663120, ISSN: 0935-9648, DOI: 10.1002/adma.201702157
- M. SHAHIDUZZAMAN ET AL: "Ionic liquid-assisted growth of methylammonium lead iodide spherical nanoparticles by a simple spin-coating method and photovoltaic properties of perovskite solar cells", RSC ADVANCES, vol. 5, no. 95, 8 September 2015 (2015-09-08), pages 77495-77500, XP055663096, GB ISSN: 2046-2069, DOI: 10.1039/C5RA08102E
- LEE KISU ET AL: "A highly stable and efficient carbon electrode-based perovskite solar cell achieved via interfacial growth of 2D PEA 2 PbI 4 perovskite", JOURNAL OF MATERIALS CHEMISTRY A, vol. 6, no. 47, 15 November 2018 (2018-11-15), pages 24560-24568, XP055792001, GB ISSN: 2050-7488, DOI: 10.1039/C8TA09433K

## Description

### Field of the invention

The present invention relates to a perovskite precursor solution for preparing a humid air-stable perovskite layer and the method of deposition of a perovskite layer, and to solar cells obtained using such a perovskite layer.

### Background art

Perovskite solar cells (PSCs) have experienced considerable recent development, with major improvements in power conversion efficiency (PCE). In particular, hybrid organic-inorganic perovskite light harvesters belong to an interesting class of materials which exhibit a suitable band gap, high absorption coefficients, long charge mobility and long diffusion length, combined with easy and low-cost processing methodologies. Organic-inorganic lead halide perovskite solar cells (PSCs) have been attracting increasing attention in the past few years due to the amazing rise in their power conversion efficiency (PCE) from 3.8% [Ref.1] to 25.2% [Ref.2] However, the stability of the PSC devices under working conditions still remains challenging. There were numerous approaches that have been applied to tackle this issue up to now:
(1) doping 2-D perovskites into 3-D perovskite. For example, by treatment of the perovskite with phenyl ethyl-ammonium iodide (PEAI), the PEAI can reach the 3D perovskite surface, reacting with excess PbI₂, leading to in situ growth of PEA₂PbI₄ as a 2D perovskite interlayer. The thus formed 2D/3D hybrid structure at the interface can significantly improve the performance of the perovskite solar cell [Refs. 4, 5];
(2) tuning the composition of perovskite [Ref. 6] or applying methylammonium iodide free precursors [Ref. 7]. In addition, compositional substitution within the 3-D perovskite network can strengthen the hydrogen bonding within the 3D-perovskite structure, optimize the tilting of the octahedral structure of PbI₆ [Ref. 8] and improve the overall stability [Ref. 9] ;
(3) adopting passivation techniques [Ref. 10]. Passivation by fumigation [Ref. 11] or through laser irradiation [Ref. 12] of the perovskite film can improve the uniformity of the film and repair the defects in the film for increased light harvesting. Passivation of the perovskite film with volatile organic Lewis bases such as pyridine [Ref. 21] or gaseous methylamine [Ref. 22] have been reported.

In addition to the above mentioned approaches, adding some additives in the perovskite precursor can improve the efficiency and stability for PSCs:
(a) For instance, incorporation of large cations into the perovskite structure. Guanidinium has been utilized as an effective large cation additive to stabilize the PSCs with high PCE, enhancing the stability owing to formation of additional hydrogen bonds [Ref. 13];
(b) Doping perovskite with imidazolium-based ionic liquids (ILs) containing fluorinated chains [Ref. 14] or allyl groups [Ref. 15] in the cation can improve the quality of the perovskite film, increase the hydrophobicity of the film surface protecting the hydrolysis when exposed to moisture and thus increase the stability;
(c) Doping perovskite with self-polymerizable imidazolium-based ionic liquids [Ref. 16] can effectively add a protection layer to the perovskite film, allowing the perovskite solar cells to be manufactured in air.

Ionic liquids (ILs) are non-volatile salts with high thermal stability and electrochemical stability due to their strong electrostatic forces between their molecular ions. ILs have been widely used as additives [Ref. 17].

### References:

[1] Kojima, A., et. al. J. Am. Chem. Soc. 131, 6050-6051(2009);
[2] NREL, Best Research Cell-Efficiency: https://www.nrel.gov/pv/cell-efficiency.html
[3] Grancini, G.; Nazeeruddin, M. K. Nature Reviews Materials 2019, 4, 4. [3] Min, H.
[4] S Li, L. Hu, C. Zhang, Y. Wu, Y. Liu, Q. Sun, Y. Cui, Y. Hao, Y. Wu, J. Mater. Chem. C, 2020, 8, 2425-2435.
[5] K. Lee, J. Kim, H. Yu, J. W. Lee, C.-M. Yoon, S. K. Kim, J. Jang, J. Mater. Chem. A, 2018, 6, 24560.
[6] Min, H. et al., Science 2019, 366, 749.
[7] Gao, X.-X, et.al, Adv. Mater. 2020, 32, 1905502.
[8] R. Prasanna, A. Gold-Parker, T. Leijtens, B. Conings, A. Babayigit, H.-G. Boyen, M. F. Toney, M. D. McGehee, J. Am. Chem. Soc. 2017, 139, 11117.
[9] D. Ghosh, P. W. Atkins, M. S. Islam, A. B. Walker, C. Eames, ACS Energy Lett. 2017, 2, 2424.
[10] Kanda, H.; Energy Environ. Sci. 2020, 13, 1222.
[11]Z. Shao, Z. Wang, Z. Li, Y. Fan, H. Meng, R. Liu, Y. Wang, A. Hagfeldt, G. Cui, S. Pang, Angew. Chem. Int. Ed. 2019, 58, 5587.
[12] X.-L. Trinh, N.-H. Tran, H. Seo, H.-C. Kim, Solar Energy, 2020, 206, 301.
[13] Jodlowski, A. D. et.al., Nat. Energy 2017, 2, 972.
[14] R. Xia, Z Fei, N. Drigo, F. D. Bobbink, Z. Huang, R. Jasiu̅nas, M. Franckevičius, V. Gulbinas, M. Mensi, X. Fang, C. Roldán-Carmona, M. K. Nazeeruddin, P. J. Dyson, Adv. Funct. Mater. 2019, 29, 1902021.
[15] Y. Zhang, Z. Fei, P. Gao, Y. Lee, F. F. Tirani, R. Scopelliti, Y. Feng, P. J. Dyson, M. K. Nazeeruddin, Adv. Mater. 2017, 29, 1702157.
[16] X. Xia, X.-X. Gao, Y. Zhang, N. Drigo, V. Queloz, F. F. Tirani, R. Scopelliti, Z. Huang, X. Fang, S. Kinge, Z. Fei, C.a Roldán-Carmona, M. K. Nazeeruddin, P. J. Dyson, Adv. Mater. 2020, 2003801
[17] Torimoto, T.; Adv. Mater. 2010, 22, 1196.
[18] D. Zhao, Z. Fei, R. Scopelliti, P. J. Dyson, Inorg. Chem. 2004, 43, 2197.
[19] Z. Fei, D. Zhao, D. Pieraccini, W. H. Ang, T. J. Geldbach, R. Scopelliti, C. Chiappe, P. J. Dyson, Organometallics 2007, 26, 1588.
[20] Paul Dyson, Dongbin Zhao, Zhaofu Fei, WO 2005/019185
[21] N. K. Noel, A. Abate, S. D. Stranks, E. S. Parrott, V. M. Burlakov, A. Goriely, H. J. Snaith, ACS Nano 2014, 8, 9815.
[22]Y. Zhang, G. Grancinia, Z. Fei, E. Shirzadi, X. Liu, E. Oveisic, F. F. Tirani, R. Scopelliti, Y. Feng, M. K. Nazeeruddin, P. J. Dyson, Nano Energy, 2019, 58, 105-111.
[23] G. Sadoughi, D. E. Starr, E. Handick, S. D: Stranks, M. Gorgoi, R. G. Wilks, M. Bär, H.J. Snaith, M. Baer, ACS Appl. Mater. Interfaces 2015, 7, 13440.
   In addition to the references cited above, [Ref. 24] below teaches the use, in the synthesis of perovskite films, of iodides of imidazoles with a methyl group on one nitrogen atom and -CH₂-CH=CH₂, -CH₂-C≡CH or -CH₂-C≡N on the other nitrogen atom. [Ref. 25] below presents the use in a similar context of 1-Hexyl-3-methylimidazolium chloride, and [Ref. 26] the use of phenylethylammonium iodide.
[24] Zhang et al., Adv. Mater., 2017, 29 1702157
[25] Shahiduzzaman et al., RSC Adv. 2015, 5, 77495-77500
[26] Lee et al., J. Mater. Chem. A, 2018, 6, 24560-24568

### Summary of the Invention

With a view notably to providing improved stability for perovskite solar cells, in particular for long-term use and/or in the presence of air, the present invention has been achieved.

In one aspect, the present invention thus relates to a perovskite precursor composition comprising:
- perovskite precursors; and
- a salt of a cationic imidazole derivative in which at least one of the two nitrogen atoms in the imidazole ring is linked to a carbon chain bearing a cyano (-C=N) group, wherein the cationic imidazole derivative has the formula (1) or the formula (2): 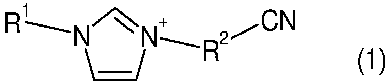 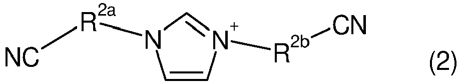
wherein, in formula (1):
R¹ is C1-C4 alkyl, more preferably C1-C3 alkyl, and most preferably methyl; and
R² is -(CH₂)ₙ- wherein n is 2 to 4, and most preferably n is 2 or 3; and
in formula (2):
   R^{2a} is -(CH₂)ₐ- wherein a is 2 to 4, and most preferably a is 3; and
   R^{2b} is -(CH₂)_{b}- wherein b is 2 to 4, and most preferably b is 3.

Here, in the above-mentioned perovskite precursor composition, the anionic counterion for the cationic imidazole derivative of formula (1) or formula (2) is a halide anion which is one or more among Cl⁻, Br⁻ and I⁻, and is most preferably Cl⁻.

In preferred specific examples, the salt of the cationic imidazole derivative is one of the following:

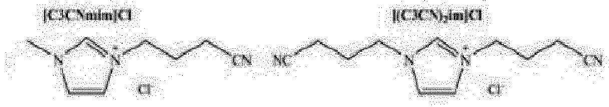

Salts of ionic liquid imidazolium species with many types of N-borne side chain are widely used notably as solvents in catalytic reactions, and in electrochemical applications. They are prepared and available not only with halide (such as chloride, bromide and iodide) anion counterions, but also with nitrate or acetate, dicyanamide, or fluorinated anions such as BF₄⁻, PF₆⁻, trifluoromethane sulfonate, bis(trifluoromethyl sulfonyl)imide etc. The most preferred imidazolium salts [C3CNmim]Cl and [(C3CN)₂im]Cl used in the present invention are all commercially available, for example from the suppliers Sigma-Aldrich, Alfa Chemistry, ABClabtory Scientific. Methods of synthesis of [C1CNmim]Cl and [C3CNmim]Cl have further been described in Zhao et al., Inorg. Chem. 2004, 43, 6, 2197-2205, and for [(C3CN)₂im]Cl in Zhao et al., Chem. Commun., 2004, 2500-2501. As a further example of interest in the present invention, [C4CNmim]Cl is commercially available from Chemieliva Pharmaceutical, and its synthesis is described in Zhao et al., Inorg. Chem. 2004, 43, 6, 2197-2205.

In the perovskite precursor composition of the present invention, in addition to a salt of a cationic imidazole derivative in which at least one of the two nitrogen atoms in the imidazole ring is linked to a carbon chain bearing a cyano (-C=N) group, as perovskite precursors, one may preferably use ABX₃ materials wherein:
A are organic cations and/or Group 1 metal cations, the organic cations being preferably at least one selected from the group consisting of: methylammonium (MA), butylammonium (BA), formamidinium (FA) and guanidinium (GUA); and the Group 1 metal cations being Cs and/or Rb;
B being at least one metal selected from the group consisting of: Pb, Sn, Bi, Cu, Ag and their mixtures, wherein B is preferably Pb; and
X being halides such as Cl, Br, I and their mixtures.

### Brief description of the drawings

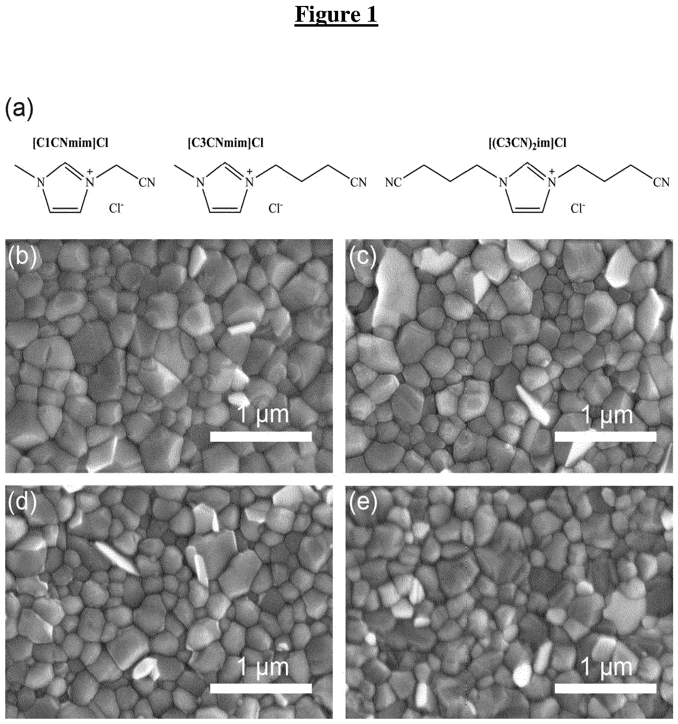

Figure 1(a) shows the molecular structures of ionic liquids (ILs) including [C1CNmim]Cl, [C3CNmim]Cl and [(C3CN)₂im]Cl. Figures 1(b) to 1(e) show top-view scanning electron microscopy (SEM) images of triple cation (Cs_{0.08}FA_{0.8}MA_{0.12})Pb(I_{0.88}Br_{0.12})₃ perovskite films with different ILs: (b) with [C1CNmim]Cl, (c) with [C3CNmim]Cl, (d) with [(C3CN)₂im]Cl. Figure 1(e) shows top-view SEM images of triple cation (Cs_{0.08}FA_{0.8}MA_{0.12})Pb(I_{0.88}Br_{0.12})₃ perovskite films without IL. The scale bar in the insets is 1 µm.

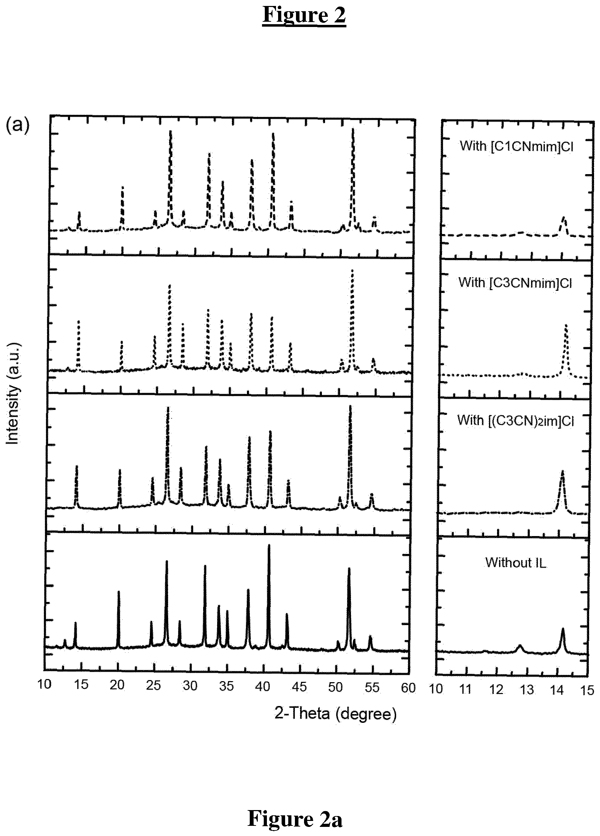

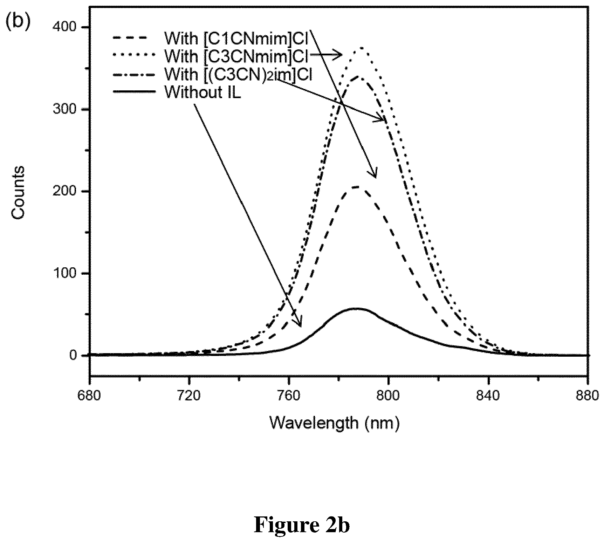

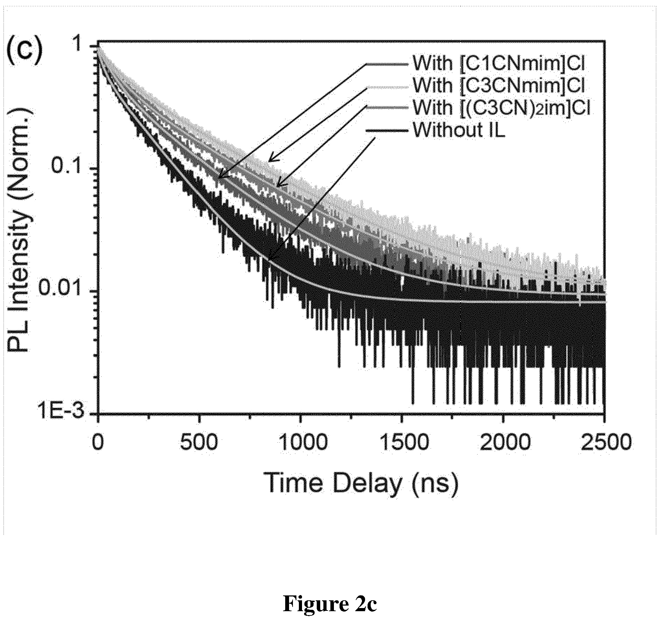

Figure 2(a) shows X-ray diffraction (XRD) patterns of perovskite films with [C1CNmim]Cl, [C3CNmim]Cl, [(C3CN)₂im]Cl and without IL using triple cation perovskite composition (Cs_{0.08}FA_{0.8}MA_{0.12})Pb(I_{0.88}Br_{0.12})₃. All patterns were directly collected on the perovskite/SnO₂/mp-TiO₂/cp-TiO₂/FTO films with the original scale in diffraction intensity. The right column is the zoom-in view of the (110) diffraction peak of perovskite and (001) peak of PbI₂. Figure 2(b) shows steady-state photoluminescence spectra for perovskite films with [C1CNmim]Cl, [C3CNmim]Cl, [(C3CN)₂im]Cl and without IL. Figure 2(c) shows time-resolved photoluminescence spectra for perovskite films with [C1CNmim]Cl, [C3CNmim]Cl, [(C3CN)₂im]Cl and without IL, coated with glass/perovskite.

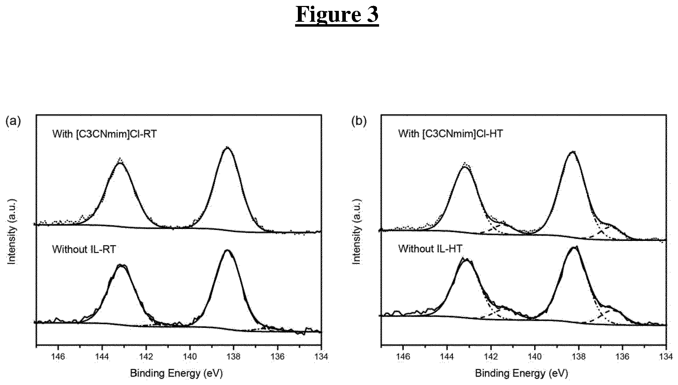

Figure 3 shows high-resolution X-ray photoelectron spectroscopy (XPS) of perovskite films on FTO/cp-TiO₂/mp-TiO₂/SnO₂. Figure 3(a) shows Pb 4f spectra for perovskite films with [C3CNmim]Cl and without IL after storing in the air for 3 days (RH≈50%). Figure 3(b) shows Pb 4f spectra for films with [C3CNmim]Cl and without IL after heating at 150°C in air for 30 minutes (RT= room temperature, HT=heating temperature).

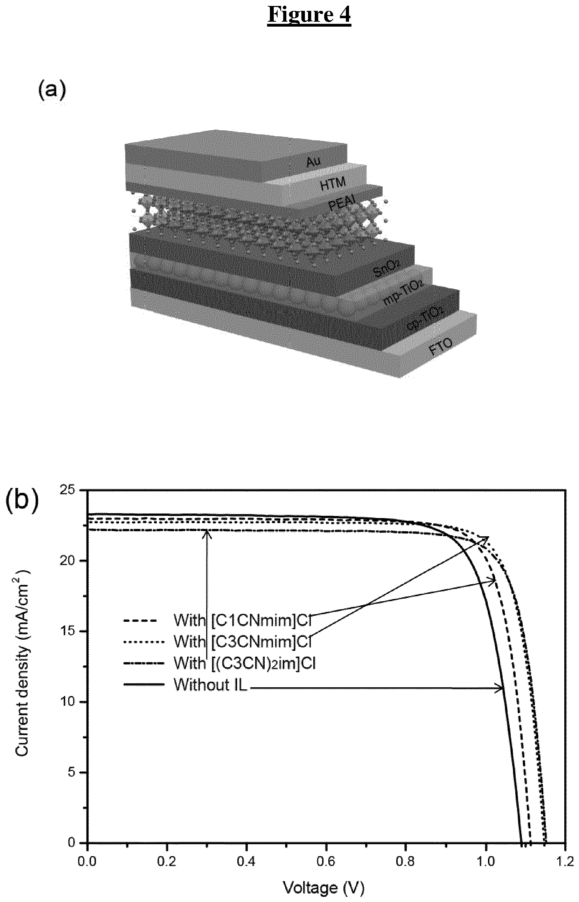

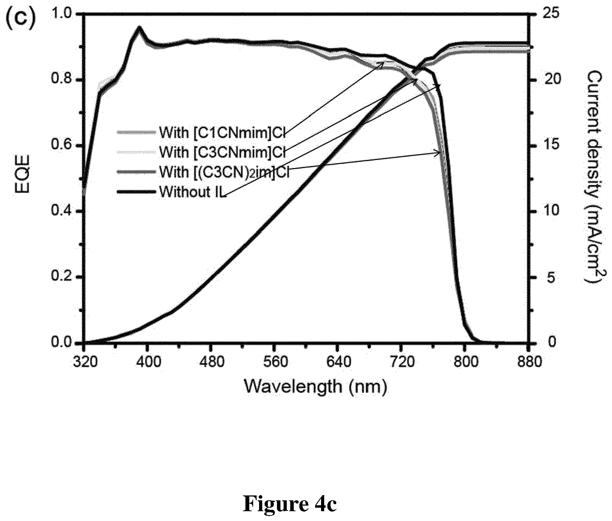

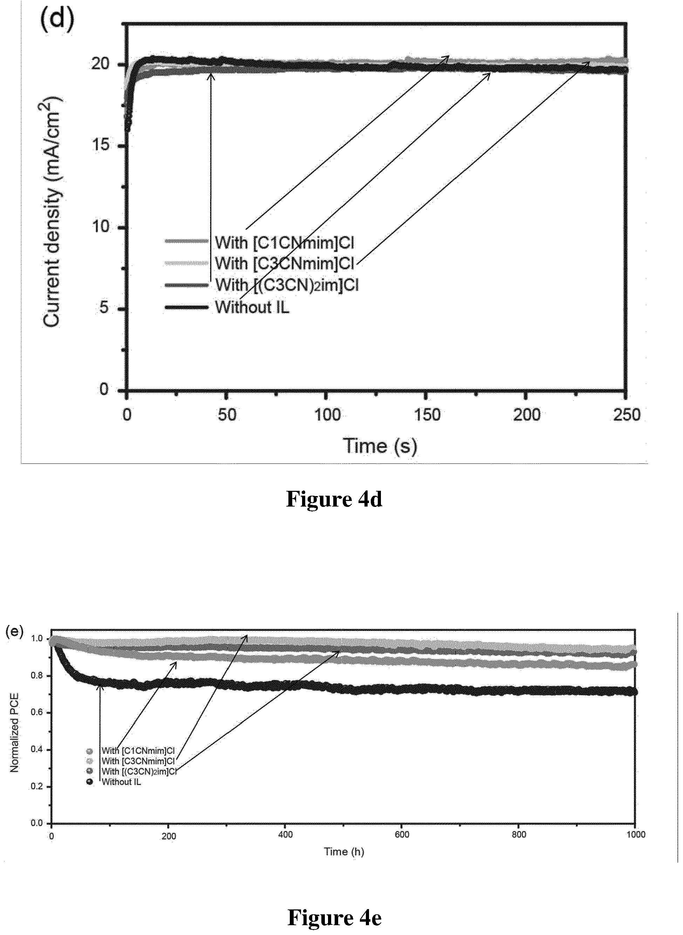

Figure 4(a) shows a schematic diagram of PSC device structure. Figures 4(b) to 4(e) show performance comparisons with all kinds of PSCs including ones with ILs ([C1CNmim]Cl, [C3CNmim]Cl, [(C3CN)₂im]Cl) and without IL. Figure 4(b) shows J-V curves of best-performing devices at reverse scans. The scanning speed is 0.08 V s⁻¹ and the active area is 0.16 cm². Figure 4(c) shows an EQE spectra curve of the best-performance devices and the integrated Jsc curves of the best-performance devices. Figure 4(d) shows steady-state photocurrent output at the maximum power point. Figure 4(e) shows a stability study shown as in situ measured PCEs of with ILs and without IL PSCs without encapsulation over 1000 h under nitrogen.

### Detailed description of the invention

In the present invention, functionalized ILs containing CN functional groups in the imidazolium cation were used as additives to add to a perovskite layer. Without wishing to be bound by any particular theory, it is believed that the pre-installed CN group in the cation of the ILs can function as a Lewis base for coordination to the Pb(II) center in the formation of the 3-D perovskite structure. It is further believed that the coordination of the CN group to the Pb(II) will compete with the I/Br anion in the formation of the 3-D perovskite film, slowing the nucleation process, resulting in formation of film with increased uniformity and less defects. The Cl anion can be encapsulated in the 3-D network for strengthening of the hydrogen bonding and optimizing the structure tilting for increased stability. Different ILs with different lengths of the alkyl chains have been studied.

Based on the results of SEM, XRD, UV and PL, the present inventors concluded that as regards the influence of IL on photovoltaic performance, the ILs studied with cyano (CN) groups, compared with the ILs without CN groups, probably on account of a role of the CN group for coordination to the Pb(II) center in the formation of the 3-D perovskite structure, result in better film quality. Further, the Cl anion that can be encapsulated inside the 3-D perovskite structure is believed to form much stronger hydrogen bonds with protons in the methylammonium(MA)/formamidinium(FA) cation, locking the protons in rigid positions and preventing the phase transformation for increased stability. As a result, PSCs modified with CN functionalized ILs show not only improved open circuit voltage and fill factor of PSCs, but also reduced the risk of exposure to the atmosphere, leading to significant enhancement of device stability.

### <Organic-inorganic hybrid perovskites>

The term "organic-inorganic hybrid perovskites", hereinafter also referred to as "hybrid perovskites", as used herein, refers to ABX₃ materials with A being organic cation groups such as methylammonium (MA), butylammonium (BA), formamidinium (FA), or the alkali metals Cs or Rb, and their mixtures; B being a metal such as Pb, Sn, Bi, Cu, Ag and their mixtures; and X being halides such as Cl, Br, I and their mixtures. More generally, a perovskite can be represented by the formula A1_{w}A2ₓA3_{(1-w-x)}B1_{y}B2_{(1-y)}X1_{z}X2_{(3-z)}, wherein A1, A2 and A3 are the same or different organic cation groups such as methylammonium (MA), butylammonium (BA), formamidinium (FA), or the alkali metal cations Cs⁺ or Rb⁺; w and x are both 0 or more and 1 or less; B1 and B2 are the same or different metals such as Pb, Sn, Bi, Cu or Ag; y is 0 or more and 1 or less; X1 and X2 are the same or different halides such as Cl, Br or I; and z is 0 or more and 1 or less. Preferred organic-inorganic hybrid perovskites in the present invention have lead (Pb) as the majority metal B in molar terms, and most preferably lead (Pb) is the sole metal B, so that the perovskite is of the form A1_{w}A2ₓA3_{(1-w-x)}PbX1_{z}X2_{(3-z)}. More preferably X1 and X2 are Br and I.

Layered perovskites contain additional bulkier molecules such as phenethylamine (PEA) or phenyethylammonium, hexylammonium (HA) and longer chain ammonium species, which confine different perovskite domains into different repeating units. Specific examples given here comprise inorganic metal-halide multi-layered perovskites. These examples are non-limiting.

In an appropriate perovskite (precursor) material for the present invention, a combination of caesium (Cs) metal cation and organic cations such as formamidinium (FA) and/or methylammonium (MA) may be used. A particularly preferred cation system is the triple cation system Cs-FA-MA. The anions used as perovskite (precursor) material for the present invention may appropriately contain a mixture of iodide (I) and bromide (Br) anions. A particularly preferred peroxide precursor system is (Cs_{0.08}FA_{0.8}MA_{0.12})Pb(I_{0.88}Br_{0.12})₃.

### Perovskite precursors

The choice of perovskite precursors may determine the material's optoelectronic properties, such as band-gap energy, charge-transport, and/or binding energy, which affect the performance of the final device.

Perovskite precursors used in the composition of the present invention are not particularly limited.

In one embodiment, the precursors are:
(A) at least one organic halide compound(s) and/or cesium or rubidium halide; and
(B) at least one halide of a metal chosen from Pb, Sn, Bi, Cu, Ag and their mixtures and most preferably Pb.

The at least one organic halide compound in the (A) precursor can be, for example, at least one selected from the group consisting of methylammonium (MA), formamidinium (FA), phenylethylammonium (PEA) and guanidinium (GUA). Particular examples of metal halide in the (B) precursors are PbCl₂, PbBr₂, PbI₂. It may be noted that metal carboxylates, particularly lead (Pb) carboxylates such as Pb (CH₃COO)₂ may be used instead of metal halides.

### Perovskite coating solution

Ionic liquids (ILs) have no vapor pressure and cannot evaporate. In this respect, ILs are not a traditional solvent that can be removed after spin-coating and aging at 100°C - ILs will stay. Furthermore, ionic liquids may form eutectic liquids (mixtures of several ion pairs, such as cations MA; FA, imidazolium cation, anions: I⁻, Cl⁻) with components from the perovskite solution. The nucleation process from a eutectic liquid is slower than in pure DMSO or DMF.

In addition to ionic liquids (ILs) of the present invention, a solvent can appropriately be added to the mixture of perovskite precursor components and can be, for example, dimethylsulfoxide (DMSO), dimethylformamide (DMF), a combination of DMSO:DMF, gamma-butyrolactone (GBL), N-methyl-2-pyrrolidone (NMP), dimethylacetamide (DMAc) and acetonitrile (ACN).

A preferred solvent is, for example, DMSO or DMF or gamma butyrolactone.

An appropriate concentration of the perovskite precursors, in terms of Pb, is from 0.6 to 1.4 M (mole per litre). The amount of functionalized ILs as dopants in the perovskite precursor composition is appropriately between 0.5 and 1.0 mol% of functionalized IL dopants with respect to the amount of perovskite metal atom other than Cs or Rb, for example with respect to the amount of Pb in the most common case of a lead-based perovskite. An exemplary amount of functionalized IL dopants with respect to the amount of perovskite metal atom such as Pb is 0.75 mol %.

### <Method of preparing a perovskite film>

In a method of preparing a perovskite film on a substrate according to the present invention, the method comprises the steps of:
(A) preparation of a perovskite precursor composition according to the invention;
(B) providing a substrate;
(C) formation of a perovskite film on the surface of the substrate.

The perovskite film can be formed, for example, by spin-coating, printing, slot-die coating and meniscus coating. The slot-die coating method is preferable for large-area deposition.

In the above-mentioned method of preparing a perovskite film according to the present invention, the substrates may appropriately be flexible or rigid conductive substrates.

### <Perovskite solar cell>

A perovskite solar cell, such as may be prepared using the perovskite film or layer of the present invention as set out above, may comprise the following layers:
(a) a transparent conducting layer;
(c) a perovskite layer;
(e) an electrode layer

Preferably, the perovskite solar cell can further comprise one or more of: (b) an electron transport layer; (b') an electron-blocking layer; (d) a hole transport layer; and (d') a hole-blocking layer.

The presence of at least one of these layers leads to a higher device efficiency.

The above-mentioned three layers can be disposed in the order of appearance above. Further, an electron transport layer can be situated between the transparent conducting layer and the perovskite layer, and a hole transport layer can be situated between the perovskite layer and an electrode layer.

In one embodiment, the perovskite solar cell may have a conventional n-i-p structure comprising a transparent conducting layer, an electron transport later, a perovskite layer, a hole transport layer and an electrode layer in this order.

In another embodiment, the perovskite solar cell may have an inverted p-i-n structure comprising a transparent conducting layer, a hole transport later, a perovskite layer, an electron transport layer and an electrode layer in this order.

In still another embodiment, the perovskite solar cell can further comprise mesoporous scaffold, in the perovskite layer.

Generally, in the so-called p-i-n or n-i-p structures, the electron (n) or hole (p) blocking layers are situated in the bottom and top of the perovskite layer (i), in a sandwich configuration, with the perovskite layer (i) being in the middle. A mesoporous TiO₂ layer is usually an electron transport layer (in the n side), but it could also be a hole transport layer (p side).

### <(a) Transparent conductive layer>

A transparent conductive layer is not particularly limited and can comprise or consist of, for example, a fluorine-doped tin oxide (FTO), indium tin oxide (ITO), doped zinc oxide, carbon nanotube networks or graphene, and preferably an FTO.

### <(b) Electron transport layer (ETL)>

The electron transport layer is not particularly limited and can comprise or consist of, for example, TiO₂, SnO₂, Nb-doped SnO₂, Sb-doped SnO₂, C60 and C60 derivatives, bathocuproine (BCP), a combination of C60/BCP, and a combination of TiO₂/SnO₂ bilayer.

Among these materials, a combination of TiO₂/SnO₂ layer is preferred for n-i-p configuration, and a combination of C60/BCP is preferred for p-i-n configuration.

### < (b') Hole-blocking layer>

An optional hole blocking layer can be, for example, 2,9-dimethyl-4, 7-diphenylphenanthroline (BCP), TiO₂, ZnO.

When the electron transport layer (ETL) material is TiO₂, TiO₂ behaves as both electron transport and hole blocking, given that the layer is compact. However if the ETL material is mesoporous, the perovskite solution infiltrates and touches the FTO electrode (which will produce losses). In order to avoid the direct contact between perovskite and FTO when the ETL material is mesoporous, typically a compact layer of TiO₂ may be advantageously incorporated between FTO and mesoporous-TiO₂ (blocking layer).

### < (d') Electron-blocking layer>

An optional electron blocking layer can be, for example, AlGaN.

### <(d) Hole transport layer>

The hole transport layer is not particularly limited, and can comprise of consist of, for example, spiro-OMeTAD (2,2',7,7'-tetrakis-(N,N'-di-p-methoxyphenylamine)-9,9'-spirobifluorene), pyrene-based materials (such as PY-1, PY-2, PY-3), Truxene-core based materials, phenothiazine-based materials, acridine-, thiophene-, biphenyl-, bithiophene-, tetrathiophene-, difluorobenzene and phenyl-based materials, triazine-based materials, benzotrithiophen- and squaraine-based materials, fluorine- and spiro-fluorene-based materials and carbazole-based materials, phthalocyanines, carbon, metal complexes, CuNCS, NiOₓ, and preferably spiro-OMeTAD.

### <(e) Electrode layer>

The electrode layer is not particularly limited and can comprise or consist of, for example, Au, C, Ag, Cu or Al. Among these, Au is preferred in the laboratory scale since it is very efficient but expensive. For industrial applications, carbon and Cu are preferred.

### <Method of preparing a solar cell device comprising a perovskite film>

The present invention also relates to a method of preparing a solar cell device comprising a perovskite film. The method of the present invention comprises the following steps:
1) preparing a transparent conducting oxide layer;
2) optionally preparing and depositing an electron transport layer;
3) optionally preparing and depositing a hole-blocking layer;
4) preparing and depositing a perovskite layer;
5) optionally preparing and depositing an electron-blocking layer
6) optionally preparing and depositing a hole transport layer; and
7) preparing and depositing an electrode layer

### <(1) Preparing a conducting oxide layer>

A conductive oxide layer can for example be prepared on an FTO glass. In such a method, an etched FTO glass is cleaned and then its surface is treated, and can be later treated for example by spin-coating a TiO₂ layer which acts as electron transport layer.

A person skilled in the art knows applying an appropriate preparation method for a given conducting oxide layer material.

### <(2) Optionally preparing and depositing an electron transport layer (ETL)>

An optional electron transport layer can for example be prepared with TiO₂, for example by spin-coating followed by annealing.

When the ETL material is TiO₂, TiO₂ behaves as both electron transport and hole blocking material, given that the layer is compact. However if the ETL material is mesoporous, the perovskite solution may infiltrate and touch the FTO electrode (which will produce losses). In order to avoid the direct contact between perovskite and FTO when the ETL material is mesoporous, commonly a compact layer of TiO₂ is incorporated between the FTO and mesoporous-TiO₂ (blocking layer). Therefore optionally, a TiO₂-blocking layer can be deposited before between the conductive layer and an electron transport layer.

### <(3) Optionally preparing and depositing a hole-blocking layer>

A person skilled in the art knows applying an appropriate preparation method for a hole-blocking material.

If the hole-blocking layer material is an organic material, like BCP, it can be prepared from solution (spin coating from organic solvent like chlorobenzene) or via thermal sublimation.

If the hole-blocking layer material is an inorganic material, like TiO₂, it can be prepared by spin-coating a precursor solution and then thermal annealing. For example, a diluted titanium diisopropoxide bis(acetylacetonate) solution (Sigma-Aldrich) in ethanol can be applied by spray pyrolysis at 450C.

A person skilled in the art knows applying an appropriate preparation method for a given electron transport layer material.

### <(4) Preparing and depositing a perovskite layer>

A perovskite solar layer can be deposited by the method as disclosed above, using a perovskite precursor solution as disclosed above. This step can be conducted in ambient air (the temperature was around 25 °C and humidity was about 30-50% RH).

A person skilled in the art knows applying an appropriate preparation method for a given perovskite layer material.

### <(5) Optionally preparing and depositing an electron-blocking layer>

A person skilled in the art knows applying an appropriate preparation method for an electron-blocking material.

If the electron-blocking layer material is an organic material it could be added from solution (spin coating), like for Spiro-OMeTAD, PEDOT:PSS, PolyTPD, PTAA.

If the electron-blocking layer material is NiOx, it can be prepared from spin-coating a precursor solution and then thermal annealing.

### <(6) Optionally preparing and depositing a hole transport layer (HTL)>

An optional hole transport layer can then be formed for example by spin-coating a solution comprising Spiro-OMeTAD. This step can be conducted in ambient air (the temperature was around 25 °C and humidity was about 30-50% RH).

A person skilled in the art knows applying an appropriate preparation method for a given hole transport layer material.

### <(7) Preparing and depositing an electrode layer>

An electrode layer can be prepared for example by evaporating gold (Au).

A person skilled in the art knows applying an appropriate preparation method for an electrode layer material.

In the method of preparing a solar cell according to the invention, the method may appropriately be carried out under a relative humidity of 10% or more and 60% or less, preferably 20% or more and 50% or less, more preferably 25% or more and 45% or less, and 3 most preferably 0% or more and 40% or less.

In the method of preparing a solar cell according to the invention, in some embodiments, at least one of the steps (1) and (3) may be carried out under an ambient temperature of 15 °C or more and 30 °C or less, preferably 15°C or more and 25°C or less and most preferably 20°C or more and 25°C or less. However, the temperature of the steps may vary. The perovskite-containing layer may be appropriately deposited in ambient temperature but then annealed at a temperature of around 100°C. The steps (1) and (3) can be or not, depending on the material, carried out at ambient temperature, but for example the common TiO₂ electron transport material is deposited in ambient temperature and then annealed at high temperature 500 °C. There are alternatives, such as SnO₂ deposited at 150°C.

### Examples

The present invention is detailed below with examples, but the scope of the present invention is not to be considered to be limited to the following examples. Worked examples using the ionic liquid [C1CNmim]Cl are Reference Examples not according to the present invention.

### Perovskite precursor solutions

The precursor solution: The precursor solution (without IL) was prepared by dissolving PbI₂ (1.190 M, TCI), PbBr₂ (0.155 M, TCI), CsI (0.105 M, TCI), FAI (1.040 M, Dyesol) and MABr (0.155 M, Dyesol) in a mixed solvent of DMF: DMSO = 4:1 (volume ratio). The precursor solutions with ILs were prepared by mixing PbI₂ (1.190 M, TCI), PbBr₂ (0.155 M, TCI), CsI (0.105 M, TCI), FAI (1.040 M, Dyesol) and MABr (0.155 M, Dyesol) by adding the same molar amount of ILs (0.75 mol%), and then mixed in DMF:DMSO = 4: 1 (volume ratio).

### Device fabrication

### < Preparing a transparent conductive layer>

Fluorine-doped tin oxide (FTO) coated glass substrates (Nippon Sheet Glass, TEC8) were cleaned with detergent, deionized water, acetone and isopropanol in an ultrasonic bath for 10 min respectively. The FTO substrates were treated with an UV/Ozone cleaner for 15 min before being used.

### < Preparing a TiO₂-blocking layer>

TiO₂ compact layers (cp-TiO₂) were deposited onto the clean FTO substrates by spray pyrolysis using a titanium diisopropoxide bis-(acetylacetonate) solution (75 % in 2-propanol, Sigma-Aldrich), which was diluted in 2-propanol (99.8%, Acros Organics) at 1:15 volume ratio on 450 °C and followed by in situ annealing for 30 min.

### < Preparing and depositing mesoporous scaffold layer and electron transport layer>

The mesoporous TiO₂ (mp-TiO₂) solution, was composed of 1 g TiO₂ paste (30NR-D, Greatcell Solar) diluted in 10 ml anhydrous ethanol solution, then the meso-TiO₂ layer was deposited onto the FTO/cp-TiO₂ substrate by one-step spin-coating process at 4500 rpm for 20 s. After annealing at 125 °C for 30 min, the mp-TiO₂ films were gradually heated to 500 °C in air, and then they were baked at the same temperature for 20 min to remove organic components.

SnO₂ layers were prepared by spin-coating 0.1 M SnCl₄ aqueous (99%, Acros Organics) solution by one-step process at 3000 rpm for 20 s, then the substrates were transferred onto a hotplate and heated between 150 °C and 190 °C for 1 h. Before using, the FTO/cp-TiO₂/mp-TiO₂/SnO₂ substrates were treated with UV/Ozone for 30 min.

### < Preparing and depositing a perovskite layer>

The different kinds of perovskite precursors were spin-coated on the top of FrO/cp-TiO₂/mp-TiO₂/SnO₂ substrates at 1000 r.p.m. for 10 s and continuously at 5000 rpm for 30 s. During the second step, 100 µL of chlorobenzene was dropped on the films at 15 s. Then, the films were annealed on the hotplate at 100°C for 1h. For all PSC devices, the perovskite absorber layer was thus prepared via a one-step spin-coating method. Once the perovskite films are fabricated, the films are further treated with PEAI. Specifically, after cooling to room temperature, a solution of Phenethylammonium iodide (PEAI) diluted in isopropanol (IPA) (14.9 mg/1 mL) was spun on the substrate at 4000 rpm for 30 s.

### < Preparing and depositing a hole transport layer>

The spiro-OMeTAD solution was prepared by dissolving in chlorobenzene with 4-tert-butylpyridine, Li[TFSI] in acetonitrile, and Co [t-BuPyPz]₃ [TFSI]₃ (FK209, Dyesol) in acetonitrile at a molar ratio of spiro-OMeTAD: FK209: Li[TFSI]: TBP of 1 : 0.03 : 0.5 : 3.3. After that, 40 µL spiro-OMeTAD solution was deposited by spin-coating at 4000 rpm for 20 s on the perovskite layer as the hole transport layer (may also be called hole-transporting material (HTM) layer).

### < Preparing and depositing an electrode layer>

Finally, the Au electrode was evaporated onto the hole-transporting material (HTM) layer with a thickness of 70 nm.

### Study of grain morphology

All functionalized ILs were adopted as dopants with the same amount (0.75 mol %) in the triple-cation (Cs_{0.08}FA_{0.8}MA_{0.12})Pb(I_{0.88}Br_{0.12})₃ perovskite precursor, in order to investigate the effect of ILs according to changes in the number of the CN groups and length of the alkyl group. The perovskite solution with the different ILs was prepared using the methods as described in the experimental example section above. All samples were deposited on the FrO/cp-TiO₂/mp-TiO₂/SnO₂, then the films were annealed on the hotplate at 100°C for 1h.

Figure 1(a) shows the molecular structure of ionic liquids (ILs) including [C1CNmim]Cl, [C3CNmim]Cl and [(C3CN)₂im]Cl. Figures 1(b-e) show top-view scanning electron microscope (SEM) images of triple cation (Cs_{0.08}FA_{0.8}MA_{0.12})Pb(I_{0.88}Br_{0.12})₃ perovskite films with different ILs: (b) with [C1CNmim]Cl, (c) with [C3CNmim]Cl, (d) with [(C3CN)₂im]Cl, (e) Top-view SEM images of trip-cation (Cs_{0.08}FA_{0.8}MA_{0.12})Pb(I_{0.88}Br_{0.12})₃ perovskite films without IL. The scale bar in the insets is 1 µm.

As shown in Figures 1(b-e), SEM image of triple-cation (Cs_{0.08}FA_{0.8}MA_{0.12})Pb(I_{0.88}Br_{0.12})₃ perovskite films showed good coverage and clear grain morphology with the introduction of ILs in the perovskite precursor (Figure 1b-d), the grain sizes of perovskite films are 320 nm (with [C1CNmim]Cl), 330 nm (with [C3CNmim]Cl) and 300 nm (with [(C3CN)₂im]Cl), respectively. In contrast, surface morphology of the perovskite without IL was composed of smaller crystals in an average size of 280 nm (Figure 1e).

It has been reported that addition of low concentration of IL containing [BF₄]⁻ could slightly enlarge grain size. It is here confirmed that ILs with Cl⁻ had the same beneficial effect during the process of crystal growth. Furthermore, with the same amount of dopant concentration, it was revealed that grain size of perovskite films enlarge with the length of the alkyl unit and the number of the CN groups.

### X-ray diffraction data and study of crystallinity

In addition to the morphology, the X-ray diffraction (XRD) patterns (Figure 2a) showed that all perovskite films have similar features, indicating that introduction of low concentration of ILs did not change the perovskite structure significantly. Typically, the ~12.6° peak is attributed to the (001) peak of PbI₂, and the ~14.2° peak is assigned to the (110) peak of perovskite.

It is known that slow nucleation/crystallization process will result in formation of large grain size and high crystallinity. Since the annealing step is identical for the all perovskite films, the grain size/crystallinity difference could derive from introduction of ILs. Notably, one may observe that the film without IL exhibited lowest crystallization degree. The films with doped ILs showed stronger diffraction, suggesting better crystallinity. As shown in the right-hand column through the zoom-in view of the (110) diffraction peak of perovskite, the intensity of (110) peak increased appreciably, indicating the crystallinity of perovskite films was improved.

Further, the crystallinity of the perovskite films was enhanced in accordance with decreased values of full width at half maximum (FWHM) for the (110) peaks. Consistent with previous reports, the "without IL" films not only have poor crystallinity, but also have the trend of phase transformation to yellow phase (δ-phase) for formamidinium (FA). However, the intensity of the main diffraction peaks increased slightly with different ILs doped and no peaks at ~11.8°, suggesting enhanced crystallinity and excellent stability for perovskite films. Interestingly, the (001) peak of PbI₂ disappeared gradually with increasing the length of the alkyl unit and the number of the CN group of ILs.

### Photoluminescence studies

Steady photoluminescence (PL) and time-resolved photoluminescence (TRPL) measurements were carried out to investigate the non-radiative carrier recombination of the perovskite film and charge separation or collection processes at interface. Compared with the perovskite film without IL, the emission intensities of those with ILs perovskite films were significantly increased (Figure 2(b)). Particularly, the PL intensity of [C3CNmim]Cl was the highest and much better than that without IL. Ultraviolet-visible (UV-vis) absorption spectra of the perovskite films with [C1CNmim]Cl, [C3CNmim]Cl and [(C3CN)₂im]Cl showed that bandgaps of the perovskite films are similar compared to that without IL.

TRPL analysis was used to further validate the crystalline quality of perovskite films. Biexponential fits were performed on TRPL curves to quantify the carrier dynamics. As shown in Figure 2(c), the doped [C3CNmim]Cl perovskite films demonstrated a long PL life-time of 269.5 ns, while the PL life-time for film doped with [C1CNmim]Cl and doped [(C3CN)₂im]Cl perovskite films are 198.2 ns and 248.1 ns respectively. However, perovskite film without IL displays the shortest PL life-time of only 117.7 ns. The large reduction of PL life-time could also signify that the crystalline quality of films with IL was much better with reduced defect states than that without IL. These results are consistent with the SEM and steady PL measurement.

### X-ray photoelectron spectroscopy (XPS) studies

X-ray photoelectron spectroscopy (XPS) analysis was implemented to probe the surface composition and chemical state of all films. Perovskite films containing [C3CNmim]Cl and without IL were studied, putting the corresponding samples at room temperature for 3 days (RH≈50%) in the air and then verifying the degradation products. Figure 3 shows high resolution XPS of perovskite films on FTO/cp-TiO₂/mp-TiO₂/SnO₂. Figure 3(a) shows Pb 4f spectra for perovskite films with [C3CNmim]Cl and without IL after storing in the air for 3 days (RH≈50%). Figure 3(b) shows Pb 4f spectra for films with [C3CNmim]Cl and without IL after heating at 150°C in air for 30 minutes (RT= room temperature, HT=heating temperature).

As shown in Figure 3(a), the main peaks at 138.5 eV and 143.4 eV can be ascribed to the Pb 4f7/2 and Pb 4f5/2 of Pb-X (X: I, Br, Cl) bonds in the perovskite films respectively. Interestingly, two additional peaks at lower binding energies (136.6 eV and 141.5 eV) can be observed in films without IL, which are contributed to metallic Pb. This is evidence that perovskite films with [C3CNmim]Cl possess better air stability, reducing the risk of exposure to the atmosphere.

### Thermal stability

Furthermore, the thermal stability of films with [C3CNmim]Cl and without IL were investigated by placing the films on a hotplate at 150°C for 30 minutes in air before XPS measurements were taken. It was shown that metallic Pb was detected in both samples. However, the ratio of metallic Pb in the perovskite without IL is higher than in the perovskite with [C3CNmim]Cl, indicating that the [C3CNmim]Cl effectively improves thermal stability. The formation of metallic Pb due to the presence of the in the perovskite film has not been routinely studied [Ref. 23]. The low concentration of metallic Pb should be due to the better film quality by applying IL as additive. The presence of metallic Pb indicates the presence of iodide deficiencies in the perovskite lattice of samples. In addition, the metallic Pb species in the film were likely to act as recombination centres. From the above, the introduction of IL ([C3CNmim]Cl) can improve the air stability and thermal stability simultaneously. The increased stability of the perovskite film with [C3CNmim]Cl could be due to the increased film quality as the CN group in the cation will compete with the I/Br anion in the formation of the 3-D perovskite network, resulting in a slow crystallization process and subsequently better quality. The incorporation of the Cl anion in the 3-D perovskite bulk will strengthen the hydrogen bonding, preventing phase transformation and increase the stability.

### Perovskite solar cell performance comparison

The architecture of PSCs used was shown in Figure 4(a), with the device configuration of FTO/cp-TiO₂/mp-TiO₂/SnO₂/Perovskite/PEAI/HTM/Au. For all PSC devices, a perovskite absorber layer was prepared via a one-step spin-coating method as shown in the experimental section. Once the perovskite films are fabricated, the films are further treated with PEAI. The SEM images showed the cross-section of the devices. For comparison, devices were made of different ILs with the same concentration and identical fabrication processes. The current-density-voltage (J-V) curves of the perovskite champion devices were measured under AM 1.5G (Figure 4(b) and Table 1).

Performance comparison with all kinds of PSCs including that with ILs ([C1CNmim]Cl, [C3CNmim]Cl, [(C3CN)₂im]Cl) and without IL are shown in Figures 4(b) to 4(e). Figure 4(b) J-V curves of best-performing devices at reverse scans. The scanning speed is 0.08 V s⁻¹ and the active area is 0.16 cm². Figure 4(c) shows an EQE spectra curve of the best-performance devices and the integrated Jsc curves of the best-performance devices. Figure 4(d) shows the steady-state photocurrent output at the maximum power point. Figure 4(e) shows a stability study as in situ measured PCEs of with ILs and without IL PSCs without encapsulation over 1000 h under nitrogen.

Both the length of the alkyl unit and the number of CN groups of ionic liquids (ILs) are seen to influence the open circuit voltage (Voc) of the resulting films. It can be seen that the Voc of PSCs with IL were enhanced from PSC without IL (1.09 V) to 1.11 V (with [C1CNmim]Cl) to 1.15 V (with [C3CNmim]Cl) and 1.15 V (with [(C3CN)₂im]Cl).

The short circuit current density (Jsc) of PSCs with ILs were similar [(23.00 mA cm⁻² (with [C1CNmim]Cl) to 22.73 mA cm⁻² (with [C3CNmim]Cl) and 22.21 mA cm⁻² (with [(C3CN)₂im]Cl)), lower than that without IL (23.30 mA cm⁻²).

The fill factor (FF) of the PSCs are sensitive to the quality of the perovskite layer as well as those of the electron transport materials (ETMs) and hole transport materials (HTMs). PSCs with ILs exhibited higher FF from 0.810 (with [C1CNmim]Cl) to 0.819 (with [C3CNmim]Cl) and 0.815 (with [(C3CN)₂im]Cl).

From the above, the PSCs doped with [C3CNmim]Cl showed the best performance with a power conversion efficiency(PCE) of 21.34% among all devices doped with IL samples, compared with devices doped with [C1CNmim]Cl (20.71%) and [(C3CN)₂im]Cl (20.84%). All are higher than that without IL (19.73%).

Thus, it can be seen that perovskite solar cells doped with ILs can reach a high integrated performance. The enhancement should be ascribed to the reduced photo-generated charge recombination at the perovskite interface as evidenced by PL measurements. In general, the hysteresis between forward and reverse scanning is a key aspect to evaluate the integrated performance of PSCs. Moreover, the J-V curves of a device based on with ILs perovskite at forward and reverse scanning exhibits small hysteresis. The hysteresis of PCEs are 3% PSCs doped with [C3CNmim]Cl and 5% for PSCs without IL respectively. These results indicated that doping with ILs as additives can provide high-performance PSCs with nearly-eliminated hysteresis. Figure 4(c) shows the spectral dependence of the external quantum efficiencies (EQEs) and the corresponding integrated currents of PSCs with different conditions. It appears that all samples displayed much higher EQEs (~90 %) due to the same transport layers. In addition, it was found that the trend of the integrated current density for different devices was consistent with those obtained from the J-V measurements.

**Table 1. Champion device performance of perovskite solar cells with different ILs and without IL**

| **Perovskite** | ***V_{OC}* (V)** | ***J_{SC}* (mA cm⁻²)** | ***FF*** | ***PCE* (%)** |
|---|---|---|---|---|
| With [C1CNim]Cl | 1.11 | 23.00 | 0.810 | 20.71 |
| With [C3CNim]Cl | 1.15 | 22.73 | 0.819 | 21.34 |
| With [(C3CN)₂im]Cl | 1.15 | 22.21 | 0.815 | 20.84 |
| Without IL | 1.09 | 23.30 | 0.778 | 19.73 |

For statistical results, twenty (20) devices were fabricated. Among the devices doped with [C1CNmim]Cl, [(C3CN)₂im]Cl or without IL perovskite devices, PSC doped with [C3CNmim]Cl present substantially better performance. As can be seen from the histogram of the statistical efficiency distribution, the devices doped with [C3CNmim]Cl showed excellent performance with a narrow PCE distribution. As for the device stability test, the steady-state photocurrent density of the PSCs was firstly measured at a fixed bias potential, where the maximum output power was detected in the J-V curve. The photocurrent output of the devices with and without IL show similar performance, with only a minimal decrease observed for device without IL after 150 s compared to that of the devices with IL (Figure 4(d)). Then, the devices doped with and without IL were evaluated at the maximum power output (MPO) decay. All the PSC devices were maintained in nitrogen atmosphere under a constant illumination of 100 mW cm⁻². The current-voltage curves (J-V) were recorded every 2 h. It is clear that the devices doped with IL showed better stability than that without IL (Figure 4(e)). After 1000 h of continuous light soaking, the MPO values of the devices doped with ILs device maintained 86% (with [C1CNmim]Cl), 95% (with [C3CNmim]Cl) and 93% (with [(C3CN)₂im]Cl) respectively. In contrast, the loss for PSC without IL (70% after 1000 of their initial value) is relatively higher than that devices doped with ILs. These stability data highlighted the obvious advantage in the long-term stability of PSCs by applying ILs. It is to note that the additional treatment of the perovskite film with PEAI layer may also contribute the overall stability as strong hydrogen bonding between the cation in the ILs and the protons in the PEAI and iodide anion will arise at the interlayer between the 3-D perovskite film, IL and the PEAI. In preferred embodiments of the present invention therefore, after deposition of a perovskite film, the perovskite film/layer prepared is coated with a layer containing phenyl ethyl-ammonium iodide (PEAI).

In summary, it has thus been demonstrated that ILs containing CN group in the alkyl side of the imidazolium cation and halogen anions, preferably Cl anion, can serve as effective additives for perovskite precursor, and notably a triple cation (Cs, FA, MA) perovskite precursor, achieving the performance with better stability of the resulting PSC device. Both the length of the alkyl unit linking the imidazolium ring and the number of the CN groups influence the overall performance.

In The influence of ILs on the photovoltaic performance of PSCs could be attributed to completion effect of the CN to the I/Br anion in the formation of the 3-D perovskite film resulting better quality and encapsulation of the Cl anion due to the halide exchange Cl-I/Br which results in strengthening of the hydrogen bond for increased stability. These results indicate that doping PSCs with CN functionalized ILs not only improves the open circuit voltage and fill factor of PSCs, but also reduce the risk of exposure to the atmosphere, thus leading to significant enhancement of device stability. The PSC device demonstrated a high PCE 21.34 %, higher than that without IL. Noteworthy, the unencapsulated device retained about 95% of their original efficiencies after a 1000 h aging study.

## Claims

1. A perovskite precursor composition comprising:
- perovskite precursors; and
- a salt of a cationic imidazole derivative in which at least one of the two nitrogen atoms in the imidazole ring is linked to a carbon chain bearing a cyano (-C=N) group, **characterised in that** the cationic imidazole derivative has the formula (1) or the formula (2): 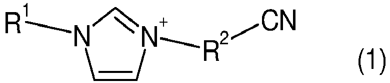 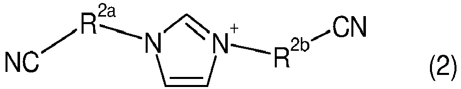
wherein, in formula (1):
R¹ is C1-C4 alkyl, more preferably C1-C3 alkyl, and most preferably methyl; and
R² is -(CH₂)ₙ- wherein n is 2 to 4; and
in formula (2):
R^{2a} is -(CH₂)ₐ- wherein a is 2 to 4; and
R^{2b} is -(CH₂)_{b}- wherein b is 2 to 4.

2. The perovskite precursor composition according to claim 1, wherein n in formula (1) is 3, and a and b in formula (2) are 3.

3. The perovskite precursor composition according to claim 1 or 2, wherein the anionic counterion for the cationic imidazole derivative of formula (1) or formula (2) is a halide anion which is one or more among Cl⁻, Br⁻ and I⁻, and is most preferably Cl⁻.

4. The perovskite precursor composition according to any of claims 1 to 3, wherein the salt of the cationic imidazole derivative is one of the following:

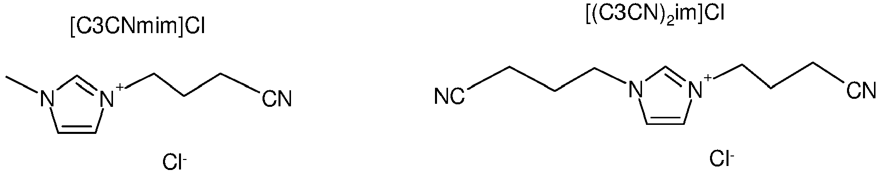

5. The perovskite precursor composition according to any one of claims 1 to 4, wherein the perovskite precursors are ABX₃ materials wherein:
A are organic cations and/or Group 1 metal cations, the organic cations being preferably at least one selected from the group consisting of: methylammonium (MA), butylammonium (BA), formamidinium (FA) and guanidinium (GUA); and the Group 1 metal cations being Cs and/or Rb;
B being at least one metal selected from the group consisting of: Pb, Sn, Bi, Cu, Ag and their mixtures, wherein B is preferably Pb; and
X being halides such as Cl, Br, I and their mixtures.

6. The perovskite precursor composition according to any one of claims 1 to 5, further containing a solvent which is one or more of: DMSO or DMF or gamma-butyrolactone.

7. Method of preparing a perovskite film on a substrate comprising the steps of:
(A) preparation of a perovskite precursor composition according to any one of claims 1 to 6;
(B) providing a substrate;
(C) formation of a perovskite film on the surface of the substrate.

8. Method of preparing a perovskite film according to claim 7, wherein step (C) is carried out through a process selected from the group consisting of: printing, slot-die coating, meniscus-coating, and spin-coating.

9. Method according to claim 7 or 8, wherein the substrate is a flexible or rigid conductive substrate.

10. Method according to any of claims 7 to 9, wherein after the formation of the perovskite film, the perovskite film is coated with a layer containing phenyl ethyl-ammonium iodide (PEAI).

11. A perovskite solar cell comprising:
(a) a transparent conductive layer;
(c) a perovskite film comprising a salt of a cationic imidazole derivative as defined in claim 1; and
(e) an electrode, optionally further comprising one or more of: (b) an electron transport layer;
(b') an electron-blocking layer; (d) a hole transport layer; and (d') a hole-blocking layer.

12. The perovskite solar cell according to claim 11 wherein the transparent conductive layer (a) comprises one or more of: fluorine-doped tin oxide (FTO), indium tin oxide (ITO), doped zinc oxide, carbon nanotube networks and graphene; and is preferably FTO.

13. The perovskite solar cell according to claim 11 or 12 wherein electron transport layer (b) comprises one or more of: TiO₂, SnO₂, Nb-doped SnO₂, Sb-doped SnO₂, C60 and C60 derivatives, bathocuprione (BCP), a combination of C60/BCP, and a combination of TiO₂/SnO₂ bilayer; and is preferably TiO₂/SnO₂ or a combination of C60/BCP.

14. The perovskite solar cell according to any one of claims 11 to 13, wherein hole transport layer (d) comprises one or more of: spiro-OMeTAD (2,2',7,7'-tetrakis-(N,N'-di-p-methoxyphenylamine)-9,9-spirobifluorene), pyrene-based materials (such as PY-1, PY-2, PY-3), Truxene-core based materials, phenothiazine-based materials, acridine-, thiophene-, biphenyl-, bithiophene-, tetrathiophene-, difluorobenzene and phenyl-based materials, triazine-based materials, benzotrithiophene- and squaraine-based materials, fluorine- and spiro-fluorene-based materials and carbazole-based materials, phthalocyanines, carbon, metal complexes, and CuNCS, NiOₓ; and is preferably spiro-OMeTAD.

15. The perovskite solar cell according to any one of claims 11 to 14, wherein electrode (e) comprises one or more of: Au, C, Ag, Cu or Al; and is preferably Au or Cu.

16. The perovskite solar cell according to any one of claims 11 to 15, wherein the solar cell further comprises mesoporous scaffold, either in n-i-p or p-i-n configuration.

17. The perovskite solar cell according to any one of claims 11 to 16, wherein the perovskite film (c) is coated with a layer containing phenyl ethyl-ammonium iodide (PEAI), the layer containing PEAI being situated between the perovskite film (c) and the hole transport layer (d) and also between the perovskite film (c) and the electrode (e).

## Patentansprüche

1. Perowskit-Vorstufen-Zusammensetzung, umfassend:
- Perowskit-Vorstufen, und
- ein Salz eines kationischen Imidazolderivats, bei dem mindestens eines der zwei Stickstoffatome in dem Imidazolring mit einer Kohlenstoffkette verknüpft ist, die eine Cyano-Gruppe (-C=N) trägt, **dadurch gekennzeichnet, dass**
das kationische Imidazolderivat die Formel (1) oder die Formel (2) aufweist: 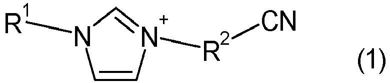 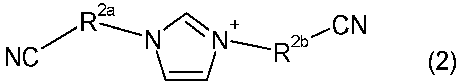 wobei in Formel (1):
R¹ für C1-C4-Alkyl, bevorzugter C1-C3-Alkyl und am bevorzugtesten Methyl steht, und
R² für -(CH₂)ₙ- steht, wobei n für 2 bis 4 steht, und
in Formel (2):
R^{2a} für -(CH₂)ₐ- steht, wobei a für 2 bis 4 steht, und
R^{2b} für -(CH₂)_{b}- steht, wobei b für 2 bis 4 steht.

2. Perowskit-Vorstufen-Zusammensetzung nach Anspruch 1, wobei n in Formel (1) für 3 steht und a und b in Formel (2) für 3 stehen.

3. Perowskit-Vorstufen-Zusammensetzung nach Anspruch 1 oder 2, wobei das anionische Gegenion für das kationische Imidazolderivat der Formel (1) oder Formel (2) ein Halogenidanion ist, bei dem es sich um eines oder mehrere aus Cl⁻, Br⁻ and I⁻ handelt und das am bevorzugtesten Cl⁻ ist.

4. Perowskit-Vorstufen-Zusammensetzung nach einem der Ansprüche 1 bis 3, wobei das Salz des kationischen Imidazolderivats eines der folgenden ist:

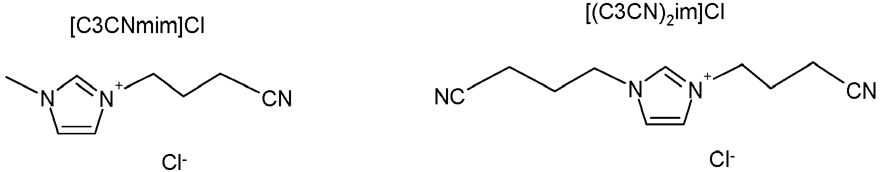

5. Perowskit-Vorstufen-Zusammensetzung nach einem der Ansprüche 1 bis 4, wobei die Perowskit-Vorstufen ABX₃-Materialien sind, wobei:
A für organische Kationen und/oder Metallkationen der 1. Hauptgruppe steht, wobei die organischen Kationen mindestens eines sind, das ausgewählt ist aus der Gruppe bestehend aus: Methylammonium (MA), Butylammonium (BA), Formamidin (FA) und Guanidin (GUA), und die Metallkationen der 1. Hauptgruppe Cs und/oder Rb sind,
B für mindestens eines steht, das ausgewählt ist aus der Gruppe bestehend aus: Pb, Sn, Bi, Cu, Ag und Gemischen derselben, wobei B bevorzugt für Pb steht, und
X für Halogenide wie etwa CI, Br, I und Gemische derselben steht.

6. Perowskit-Vorstufen-Zusammensetzung nach einem der Ansprüche 1 bis 5, die ferner ein Lösungsmittel enthält, das eines oder mehrere ist von: DMSO oder DMF oder gamma-Butyrolacton.

7. Verfahren zum Herstellen eines Perowskit-Films auf einem Substrat, umfassend die Schritte des:
(A) Herstellens einer Perowskit-Vorstufen-Zusammensetzung nach einem der Ansprüche 1 bis 6,
(B) Bereitstellens eines Substrats,
(C) Bildens eines Perowskit-Films auf der Oberfläche des Substrats.

8. Verfahren zum Herstellen eines Perowskit-Films nach Anspruch 7, wobei der Schritt (C) durch einen Prozess ausgeführt wird, der ausgewählt ist aus der Gruppe bestehend aus: Drucken, Schlitzdüsen-Beschichtung, Meniskusbeschichtung und Rotationsbeschichtung.

9. Verfahren nach Anspruch 7 oder 8, wobei das Substrat ein flexibles oder starres leitfähiges Substrat ist.

10. Verfahren nach einem der Ansprüche 7 bis 9, wobei nach dem Bilden des Perowskit-Films der Perowskit-Film mit einer Schicht beschichtet wird, die Phenylethylammoniumiodid (PEAI) enthält.

11. Perowskit-Solarzelle, umfassend:
(a) eine transparente leitfähige Schicht,
(c) einen Perowskit-Film, umfassend ein Salz eines kationischen Imidazolderivats wie in Anspruch 1 definiert, und
(e) eine Elektrode,
gegebenenfalls ferner umfassend eines oder mehrere von: (b) einer Elektronenleitungsschicht, (b') einer Elektronensperrschicht, (d) einer Lochleitungsschicht, und (d') einer Lochsperrschicht.

12. Perowskit-Solarzelle nach Anspruch 11, wobei die transparente leitfähige Schicht (a) eines oder mehrere umfasst von: fluordotiertem Zinnoxid (FTO), indiumzinnoxid (ITO), dotiertem Zinkoxid, Kohlenstoffnanoröhrennetzen und Graphen, und bevorzugt FTO ist.

13. Perowskit-Solarzelle nach Anspruch 11 oder 12, wobei die Elektronenleitungsschicht (b) eines oder mehrere umfasst von: TiO₂, SnO₂, Nbdotiertem SnO₂, Sb-dotiertem SnO₂, C60 und C60-Derivaten, Bathocuproin (BCP), einer Kombination von C60/BCP und einer Kombination einer TiO₂/SnO₂-Doppelschicht, und bevorzugt TiO₂/SnO₂ oder eine Kombination von C60/BCP ist.

14. Perowskit-Solarzelle nach einem der Ansprüche 11 bis 13, wobei die Lochleitungsschicht (d) eines oder mehrere umfasst von: Spiro-OMeTAD (2,2',7,7'-Tetrakis-(N,N'-di-p-methoxyphenylamin)-9,9'-spirobifluoren), Materialien auf Pyrenbasis (wie etwa PY-1, PY-2, PY-3), Materialien auf Basis eines Truxen-Kerns, Materialien auf Phenothiazinbasis, Materialien auf Acridin-, Thiophen-, Biphenyl-, Bithiophen-, Tetrathiophen-, Difluorbenzol- und Phenylbasis, Materialien auf Triazinbasis, Materialien auf Benzotrithiophen- und Squarainbasis, Materialien auf Fluor- und Spirofluorbasis und Materialien auf Carbazolbasis, Phthalocyaninen, Kohlenstoff, Metallkomplexen und CuNCS, NiOx, und bevorzugt Spiro-OMeTAD ist.

15. Perowskit-Solarzelle nach einem der Ansprüche 11 bis 14, wobei die Elektrode (e) eines oder mehrere umfasst von: Au, C, Ag, Cu oder AI, und bevorzugt Au oder Cu ist.

16. Perowskit-Solarzelle nach einem der Ansprüche 11 bis 15, wobei die Solarzelle ferner ein mesoporöses Gerüst in entweder n-i-p- oder p-i-n-Konfiguration umfasst.

17. Perowskit-Solarzelle nach einem der Ansprüche 11 bis 16, wobei der Perowskit-Film (c) mit einer Schicht beschichtet ist, die Phenylethylammoniumiodid (PEAI) enthält, wobei sich die PEAI enthaltende Schicht zwischen dem Perowskit-Film (c) und der Lochleitungsschicht (d) und auch zwischen dem Perowskit-Film (c) und der Elektrode (e) befindet.

## Revendications

1. Composition de précurseur de perovskite comprenant :
- des précurseurs de perovskite ; et
- un sel d'un dérivé cationique d'imidazole dans lequel au moins un des deux atomes d'azote dans le cycle d'imidazole est lié à une chaîne de carbone portant un groupe cyano (-C≡N), **caractérisée en ce que** le dérivé cationique d'imidazole a la formule (1) ou la formule (2) : 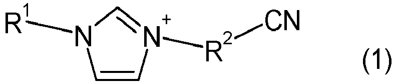 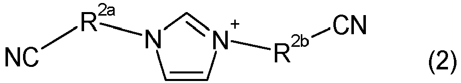
où, dans la formule (1) :
R¹ est un alkyle C1-C4, de préférence un alkyle C1-C3, et de préférence encore un méthyl ; et
R2 est -(CH₂)ₙ- où n est de 2 à 4 ; et
dans la formule (2) :
R^{2a} est -(CH₂)ₐ- où a est de 2 à 4 ; et
R^{2b} est -(CH₂)_{b}- où b est de 2 à 4.

2. Composition de précurseur de perovskite selon la revendication 1, dans laquelle n dans la formule (1) est 3, et a et b dans la formule (2) sont 3.

3. Composition de précurseur de perovskite selon la revendication 1 ou 2, dans laquelle le contre-ion anionique pour le dérivé cationique d'imidazole de la formule (1) ou de la formule (2) est un anion halogénure qui est un ou plusieurs parmi Cl, Br et I, et est de manière préférentielle Cl.

4. Composition de précurseur de perovskite selon l'une quelconque des revendications 1 à 3, dans laquelle le sel du dérivé cationique d'imidazole est l'un de ce qui suit :

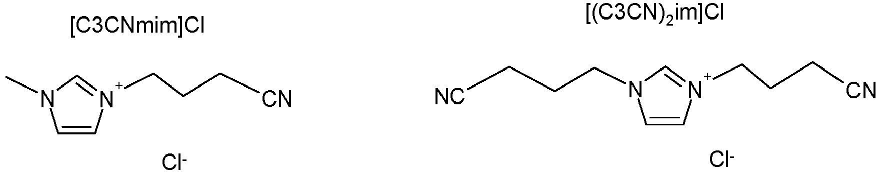

5. Composition de précurseur de perovskite selon l'une quelconque des revendications 1 à 4, dans laquelle les précurseurs de perovskite sont des matières ABX₃ où :
A sont des cations organiques et/ou des cations métalliques du groupe 1, les cations organiques étant de préférence au moins un choisi dans le groupe se composant de : méthylammonium (MA), butylammonium (BA), formamidinium (FA) et guanidinium (GUA) ; et les cations métalliques du groupe 1 étant Cs et/ou Rb ;
B étant au moins un métal choisi dans le groupe se composant de : Pb, Sn, Bi, Cu, Ag et leurs mélanges, où B est de préférence Pb ; et
X étant des halogénures tels que Cl, Br, 1 et leurs mélanges.

6. Composition de précurseur de perovskite selon l'une quelconque des revendications 1 à 5, contenant en outre un solvant qui est un ou plusieurs de : DMSO ou DMF ou gamma-butyrolactone.

7. Procédé de préparation d'un film de perovskite sur un substrat comprenant les étapes de :
(A) préparation d'une composition de précurseur de perovskite selon l'une quelconque des revendications 1 à 6 ;
(B) fourniture d'un substrat ;
(C) formation d'un film de perovskite sur la surface du substrat.

8. Procédé de préparation d'un film de perovskite selon la revendication 7, selon lequel l'étape (C) est mise en œuvre par l'intermédiaire d'un processus choisi dans le groupe se composant de : impression, enduction par filière à fente, enduction par ménisque, et enduction par rotation.

9. Procédé selon la revendication 7 ou 8, selon lequel le substrat est un substrat conducteur flexible ou rigide.

10. Procédé selon l'une quelconque des revendications 7 à 9, selon lequel, après la formation du film de perovskite, le film de perovskite est enduit d'une couche contenant de l'iodure phénylique éthylique d'ammonium (PEAI).

11. Cellule solaire en perovskite comprenant :
(a) une couche conductrice transparente ;
(c) un film de perovskite comprenant un dérivé cationique d'imidazole selon la revendication 1 ; et
(e) une électrode,
comprenant en outre de manière optionnelle un ou plusieurs de : (b) une couche de transport d'électron; (b') une couche de blocage d'électron ; (d) une couche de transport de trou ; et (d') une couche de blocage de trou.

12. Cellule solaire en perovskite selon la revendication 11 dans laquelle la couche conductrice transparente (a) comprend un ou plusieurs de : oxyde d'étain dopé au fluor (FTO), oxyde d'étain et d'indium (ITO), oxyde de zinc dopé, réseaux de nanotube de carbone et graphène ; et est de préférence du FTO.

13. Cellule solaire en perovskite selon la revendication 11 ou 12 dans laquelle la couche de transport d'électron (b) comprend un ou plusieurs de : TiO₂, SnO₂, SnO₂ dopé au Nb, SnO₂ dopé au Sb, C60 et des dérivés de C60, bathocuprione (BCP), une combinaison de C60/BCP, et une combinaison de bicouche TiO₂/SnO₂ ; et est de préférence TiO₂/SnO₂ ou une combinaison de C60/BCP.

14. Cellule solaire en perovskite selon l'une quelconque des revendications 11 à 13, dans laquelle la couche de transport de trou (d) comprend un ou plusieurs de : spiro-OMeTAD (2,2',7,7'-tetrakis-(N,N'-Di-p-méthoxyphénylamine)-9,9'-spirobifluorène), des matières à base de pyrène (telles que PY-1, PY-2, PY-3), des matières à base de noyau de truxène, des matières à base de phénothiazine, des matières à base d'acridine, de thiophène, de diphényle, de bithiophène, de tétrathiophène, de difluorobenzène et de phényl, des matières à base de triazine, des matières à base de benzotrithiophène et de squaraine, des matières à base de fluor et de spiro-fluorène et des matières à base de carbazole, des phtalocyanines, du carbone, des complexes métalliques, et CuNCS, NiOₓ ; et est de préférence du spiro-OMeTAD.

15. Cellule solaire en perovskite selon l'une quelconque des revendications 11 à 14, dans laquelle l'électrode (e) comprend un ou plusieurs de : Au, C, Ag, Cu ou Al ; et est de préférence Au ou le Cu.

16. Cellule solaire en perovskite selon l'une quelconque des revendications 11 à 15, dans laquelle la cellule solaire comprend en outre un empilage mésoporeux, dans une configuration n-i-p ou p-i-n.

17. Cellule solaire en perovskite selon l'une quelconque des revendications 11 à 16, dans laquelle le film de perovskite (c) est enduit d'une couche contenant de l'iodure éthylique phénylique d'ammonium (PEAI), la couche contenant PEAI étant située entre le film de perovskite (c) et la couche de transport de trou (d) et également entre le film de perovskite (c) et l'électrode (e).
